# DEMANDE DE BREVET EUROPEEN

(11) **EP 0 687 047 A1**
(43) Date de publication de la demande: **13.12.1995**
(21) Numéro de dépôt: 95401280.3
(22) Date de dépôt: 01.06.1995
(51) Int. Cl.: H01S 3/25

(54) **Pile de barrettes de diodes laser, et son procédé d'assemblage**

(30) Priorité: 07.06.1994 FR 9406945; 09.05.1995 FR 9505480
(71) Demandeur: THOMSON-CSF SEMICONDUCTEURS SPECIFIQUES, 75008 Paris (FR)
(72) Inventeur: Roustin, Pascal, F-92402 Courbevoie Cedex (FR); Fillardet, Thierry, F-92402 Courbevoie Cedex (FR); Leviel, Henri, F-92402 Courbevoie Cedex (FR)
(74) Mandataire: Guérin, Michel

(57) **Abrégé**

L'invention concerne un empilement de barrettes de diodes laser, pour obtenir une grande puissance optique à l'émission.

Afin d'obtenir un positionnement aisé et un bon contact thermique, chaque sous-ensemble de barrette (1+2+3) pénètre dans un sillon (18) creusé dans un support (17) commun. Le support est métallique est métallique (25) et il est isolé en surface par du carbone diamant (26) et une colle. Les sous-ensembles sont soit directement des barrettes de diodes soit des barrettes de diode (2) montées sur des lamelles (1) dont le talon (16) est inséré dans un sillon.

Application aux lasers semiconducteurs de puissance.

## Description

La présente invention concerne une pile de barrettes de diodes laser semiconductrices, ainsi que le procédé de réalisation de cette pile.

Les lasers semiconducteurs sont actuellement extrêmement répandus, dans de nombreux domaines pour lesquels seule une faible énergie (<1W) est nécessaire. Mais si une plus forte énergie (jusque ou au delà de 1kW optique, par exemple) est requise, soit on utilise des lasers à gaz, ou à excimères, ou encore des lasers solides du type Nd: YAG (grenat d'yttrium et d'aluminium dopé au néodyme). Mais ces derniers doivent être pompés optiquement et la technologie la plus homogène et efficace consiste à pomper des lasers YAG, solides, par des lasers semiconducteurs, solides également, mais qui doivent être regroupés dans des piles de barrettes de lasers semiconducteurs afin de disposer d'une énergie suffisante.

On appelle barrette de diodes une bande, découpée dans une tranche de matériaux semiconducteurs III-V, qui regroupe une pluralité de lasers élémentaires semiconducteurs, qui émettent selon une direction de l'espace. La juxtaposition d'une pluralité de barrettes donne une pile de barrettes, dont un plan latéral émet selon deux directions de l'espace, avec une puissance suffisante pour pomper un barreau de laser solide tel que Nd: YAG, Nd: YLF ou autres.

Ce type de structures, pour lequel on recherche une densité de puissance optique maximale, est utilisé pour le pompage de lasers solides, pour trois raisons principales.
- le spectre d'émission très faible (<4nm) des diodes lasers permet d'obtenir des rendements de pompage élevés,
- la longueur d'onde d'émission des diodes lasers est facilement adaptable au spectre d'absorption des principaux matériaux utilisés (YAG: 30 Nd (0,8µm), YLF: Nd (0,79µm)
- la durée de vie des diodes lasers est élevée.

Si les barrettes et les piles de barrettes de diodes laser sont en soi bien connues, la réalisation de piles - également connues en anglais sous l'appellation "stack" - est en fait assez délicate pour considérer que ce n'est pas encore une opération industrielle et qu'elle ressort plutôt du domaine du laboratoire d'applications.

Le rappel préliminaire de l'état de l'art permettra de mieux saisir les difficultés de réalisations dans des conditions industrielles.

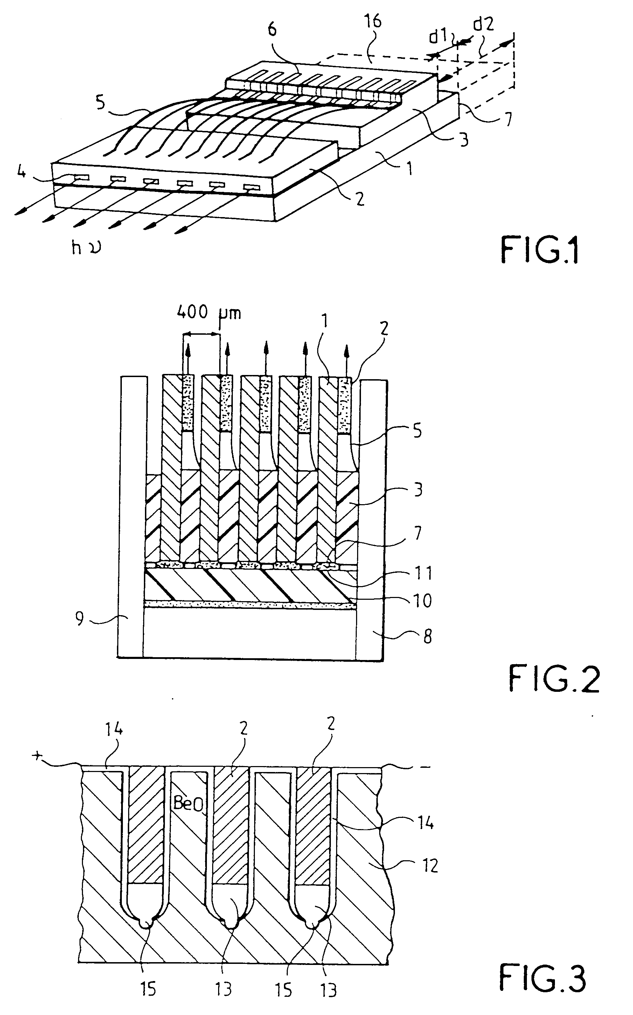

Un sous-ensemble de base de barrette élémentaire de lasers semiconducteurs est représenté en figure 1. Ce modèle, considéré dans son ensemble, est commun à de nombreux fabricants. Il comprend une embase 1 qui est une lamelle métallique, sur laquelle sont brasées, le long d'un premier bord, une barrette de diodes laser 2 et, parallèle à un deuxième bord, une cale isolante 3, qui est à une distance "d1" nulle ou faible du deuxième bord longitudinal de la lamelle 1. Cette dernière a de l'ordre de 1 cm de longueur, 2 mm de largeur et 0,2 mm d'épaisseur. La barrette 2 de lasers est un ruban découpé dans une tranche manufacturée de matériaux semiconducteurs, selon une direction telle que les lasers 4 émettent un rayonnement lumineux perpendiculaire au premier bord de la lamelle 1. La cale isolante 3 présente une face supérieure à deux niveaux qui permettent:
- d'une part de braser sur le niveau inférieur les fils ou rubans de connexions 5 des lasers 4,
- d'autre part d'assurer le contact électrique, sur le niveau supérieur, au moyen d'une ou plusieurs métallisations 6, en contact avec les fils 5.

La formation d'une pile de barrettes, ou stack, par empilement de plusieurs sous-ensembles de base tels qu'en figure 1 est donnée par la figure 2 et décrite dans le brevet US- A-5 099 488 du 24 mars 1992. Pour les cinq barrettes représentées - à titre non limitatif - le courant électrique passe en série à travers: lamelle 1, laser 2, fils 5, métallisation 6, lamelle 1... et ainsi de suite. Dans la réalité, on fait par exemple des empilements de 25 barrettes au centimètre, au pas de 0,4 mm ou 400 µm, ou à des pas variables.

Les sous-ensembles de base 1+2+3 sont serrés entre deux flancs 3 et 9 qui sont soit conducteurs, soit isolants mais munis de pistes nétalliques pour alimenter les barrettes de lasers. Mais, surtout, les dits sous-ensembles sont rendus solidaires d'une embase 10, ou matériau isolant, sur laquelle ils sont brasés par la tranche latérale 7 de la lamelle 1 au moyen d'une brasure 11.

C'est là que réside toute la difficulté industrielle: braser de 5 à 25 sous-ensembles, au pas de 400 microns, par des tranches 7 de 200 microns d'épaisseur. Soit l'épaisseur de brasure 11 est suffisante pour bien braser les sous-ensembles, mais le risque est grand que, par bavure, il y ait des court-circuits entre lamelles 1, ce qui court-circuite les lasers correspondants. Soit l'épaisseur de brasure 11 est suffisamment faible pour éviter les bavures entre lamelles 1, mais le risque est que les lamelles - et donc les sous-ensembles - soient mal fixées, et présentent une grande impédance thermique: le contact thermique entre chaque sous-ensemble 1+2+3 et le support 10 par la seule tranche 7, de 200 microns d'épaisseur de la lamelle 1 est nettement insuffisant.

Une autre démarche, décrite dans les brevets US-A-5-040-187 et 5-128-951, est illustrée en figure 3. Schématiquement, elle consiste à traiter directement les barrettes de lasers 2, sans passer par les sous-ensembles de base 1+2+3.

Une plaque 12 de céramique, d'alumine ou d'oxyde de béryllium par exemple, est creusée de sillons 13 dont les dimensions sont suffisantes pour qu'une barrette 2 pénètre dans chaque sillon 13. Puis la plaque isolante 12 reçoit une métallisation 14 du côté de la face creusée par les sillons 13. Ceux-ci ont une profondeur de l'ordre de 0,5 mm, et bien entendu la métallisation pénètre dans les sillons 13 et en recouvre les parois: elle court-circuite même les deux parois et il faut soit graver chimiquement, soit meuler le fond, en 15, pour isoler électriquement les parois de chaque sillon 13.

Pour réaliser un empilement de barrettes de lasers, la plaque 12 est courbée dans un sens qui ouvre les sillons 13: les barrettes 2 y sont introduites, puis la flexion sur la plaque est relâchée, et les sillons serrent les barrettes 2 entre leurs flancs.

Le produit et le procédé sont intellectuellement simples, mais pratiquement délicats à réaliser - c'est-à-dire pas industriels - parce qu'ils nécessitent une très grande précision d'usinage des épaisseurs des barrettes 2 et des sillons 13. Si la précision est insuffisante, et si les sillons sont trop fins, il n'est pas possible d'y remédier. S'ils sont trop larges, il ne semble pas possible d'y remédier par une épaisseur de brasure qui risquerait de court-circuiter les électrodes des lasers.

Enfin, le brevet US 5 305 344 décrit une pile de barrettes fixées par leur talon dans les rainures d'un support isolant rainuré. Ce support isolant n'a pas toujours les caractéristiques de conduction de chaleur suffisantes pour évacuer la chaleur dissipée par les diodes laser et amenée vers le support par les talons arrière des barrettes.

Les différents inconvénients de l'art connu sont évités par le produit et le procédé selon l'invention dont la conception relève d'un esprit de simplification pour faciliter l'assemblage d'un pile de barrettes laser et abaisser les prix de revient.

Selon l'invention, on propose une pile de sous-ensembles de barrettes de diodes laser, chaque sous-ensemble comportant une barrette de diodes laser, les sous-ensembles étant insérés en tout ou partie dans les sillons d'un support métallique, ces sillons étant revêtus d'un dépôt isolant pour isoler électriquement les barrettes du support.

On peut alors utiliser un support en métal très conducteur de la chaleur, du cuivre par exemple, le dépôt isolant assurant l'isolement électrique entre barrettes.

Le mot sous-ensemble de diodes laser est ici utilisé pour désigner soit un sous-ensemble du genre de celui de la figure 1 avec une barrette de diodes, une lamelle, une entretoise et des connexions, soit la barrette de diodes toute seule lorsqu'elle est montée directement sur le support.

Le dépôt isolant est de préférence un dépôt de carbone diamant pour des raisons de conductivité thermique.

La liaison électrique en série entre les différentes barrettes peut se faire différemment selon que les barrettes de diodes sont totalement insérées dans les sillons, ou que seul un talon arrière du sous-ensemble est inséré dans le sillon. Dans le premier cas, la liaison peut être assurée par un dépôt conducteur sur le dépôt isolant, ce dépôt conducteur étant conservé entre les sillons mais étant toutefois supprimé dans le fond du sillon pour ne pas court-circuiter les deux faces de la barrette. Dans le second cas, la liaison électrique peut se faire par l'extérieur du support le dépôt conducteur doit être supprimé entre les sillons mais peut être conservé en fond de sillon.

Une pile de sous-ensembles de barrettes diodes laser selon l'invention reste interchangeable avec une pile de sous-ensemble de barrettes selon l'art connu, mais sa structure est mécaniquement plus solide et thermiquement mieux équilibrée.

Les sillons ont une profondeur suffisante pour recevoir les talons de prolongation des lamelles ou les barrettes entières, et d'une largeur suffisante pour que les dits talons ou les barrettes y pénètrent avec un jeu d'ajustement. Les talons des lamelles ou les barrettes complètes sont brasés ou collés dans les sillons du support, et le positionnement précis se fait en déplaçant les lamelles dans la brasure fondue, ou dans la colle, dans des sillons qui à cet effet sont taillés larges. Le pas des sillons dans le support est bien entendu le même que le pas de la pile de barrettes de diodes.

L'invention concerne encore un procédé d'assemblage d'une pile de barrettes de diodes laser, caractérisé en ce qu'il comporte une étape préliminaire de réalisation d'un support isolant électrique à partir d'une plaque métallique bonne conductrice thermique et électrique,
- dans laquelle des sillons parallèles sont creusés,
- dont au moins la face creusée par les sillons est soumise à un dépôt de carbone diamant, qui pénètre dans les sillons, et rend les faces internes de sillons et la face creusée du support isolantes électriques,
- les barrettes de diodes lasers étant introduites dans les dits sillons et collées.

L'invention sera mieux comprise par l'exposé plus détaillé qui suit maintenant d'un exemple de réalisation de pile de barrettes de diodes laser, ainsi que le procédé de préparation du support et d'assemblage des composants, cet exposé étant fait en relation avec les figures jointes en annexes parmi lesquelles:
- la figure 1 représente, en trait plein un sous-ensemble de barrette de diodes classique, et, en traits pointillés, un sous-ensemble de barrette pourvue d'un talon permettant l'insertion dans un sillon du support selon l'invention,
- les figures 2 et 3 représentent deux exemples de piles de barrettes selon l'art connu qui ont été décrites précédemment,
- les figures 4 à 7 représentent les étapes de réalisation d'un support de l'invention, selon une première variante,
- la figure 8 représente une pile de barrette de diodes laser selon l'invention,
- la figure 9 représente un détail de l'invention selon une deuxième variante.

Le support commun à une pile de barrettes de diodes laser est essentiellement constitué de deux éléments: le corps qui présente un volume suffisant pour qu'il soit possible d'y creuser des sillons, et la surface interne des sillons qui doit permettre de fixer les talons des lamelles. Ces deux éléments doivent tous deux être bons conducteurs thermiques, mais au moins l'un des deux doit être isolant électrique.

Le corps est en métal, mais la surface des sillons est couverte par un dépôt cristallin tel que le carbone diamant (isolant électrique).

Dans une première réalisation, une pile de barrettes de diodes laser selon l'invention comporte essentiellement deux éléments: un support arrière et des sous-ensembles de barrettes de diodes. Un retour sur la figure 1 permettra de facilement discerner la différence qui caractérise une barrette de diodes selon l'invention.

Il a été exposé précédemment qu'une barrette selon l'art connu - dessinée en traits pleins - comporte une semelle qui est une lamelle métallique 1, dont le talon, qui dépasse au delà de la cale isolante 3, est d'une longueur "d1" nulle ou très faible, seulement limitée par le risque de bavures entre les brasures 11 (fig.2). Une barrette de diodes lasers selon l'invention a la même structure générale, à l'exception du talon 16 - dessiné en traits pointillés - qui prolonge la lamelle 1, au delà de la cale isolante 3, sur une longueur "d2" de l'ordre de 0,5 mm, soit environ 1/3 à 1/4 de la dimension de la lamelle 1, selon la même direction. Ce talon, qui a environ 1cm selon une direction et 0,5 mm selon une autre direction, se présente donc comme une bande, parallèle au ruban de lasers 2 et à la cale 3.

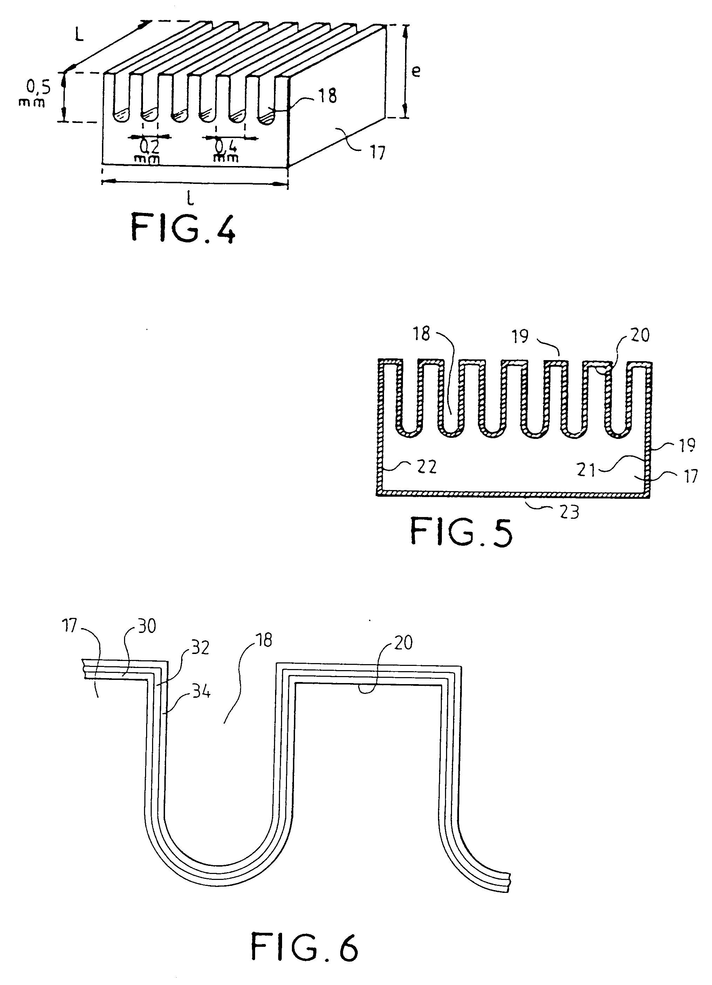

Le support qui sert à assembler une pluralité de barrettes de diodes est métallique et bon conducteur de la chaleur. Il est illustré en figures 4 à 6. C'est un bloc parallélépipèdique 17, en cuivre de préférence. Ce bloc a une première dimension "L" qui est un multiple de la longueur d'une barrette de diodes, de l'ordre de 1 cm, ou plus exactement de la longueur du talon 16 de chaque barrette de diodes modifiée selon l'invention. Il a une deuxième dimension "I" qui est en rapport avec le nombre "n" de barrettes à empiler, qui sera précisé ultérieurement. Il a enfin une épaisseur "e" qui est typiquement de l'ordre de 1 à 1,5mm.

Dans ce bloc métallique sont usinés, parallèlement à la dimension L, et parallèles entre eux, une pluralité de sillons 18 - égale au nombre de barrettes à empiler - qui ont, par exemple, une profondeur de l'ordre de 0,5 à 0,8mm, une largeur de l'ordre de 0,1 à 0,2 mm, et un pas d'environ 0,4 mm le pas étant plus précisément égal à l'épaisseur d'une barrette de diodes: épaisseur de la semelle 1 plus épaisseur de la cale isolante 3 (figure 4).

L'usinage des sillons peut être effectué par sciage ou par électroérosion.

Ce support est ensuite revêtu d'un dépôt de diamant 30, d'épaisseur typique de 1 à 5 micromètres, sur tous les côtés du bloc, ainsi que sur les faces internes et le fond des sillons (figure 5: vue de détail d'un sillon).

Le bloc est ensuite métallisé sur ses deux faces, et là encore dans les sillons, y compris sur les faces latérales de ceux-ci, par pulvérisation cathodique ou par évaporation sous vide, avec des métaux ou des combinaisons de couches métalliques à base de chrome, de titane (pour l'adhérence sur le diamant), de platine, de nickel (pour faire des couches barrières) et d'or pour sa propriété de brasabilité (figure 6). Une couche métallique 32 a été représentée.

Un dépôt de brasure (34) est ensuite effectué uniformément sur la surface rainurée. Ce dépôt, d'épaisseur typique 5 micromètres, peut être réalisé par voie électrolytique ou par dépôt sous vide. Les matériaux utilisés peuvent être des métaux comme l'étain, l'indium, ou des alliages de ces métaux (étain-plomb, indium-plomb, indium-étain, indium-argent).

Dans le cas où les sous-ensembles à monter dans les rainures sont du type de la figure 1, la métallisation 32 et la couche de brasure 24 déposées sur la face supérieure 20 du bloc entre deux sillons adjacents doit être supprimée, par exemple, par rodage, car elle court-circuiterait les barrettes placées dans des rainures adjacentes.

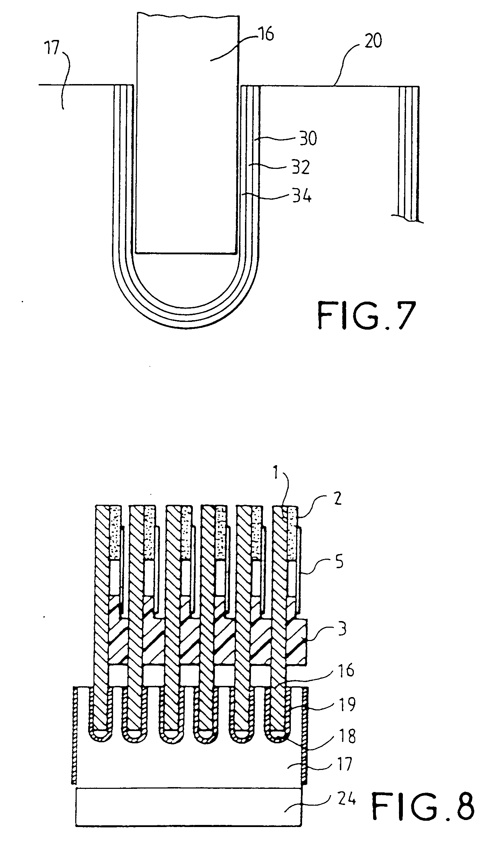

Les barrettes, similaires à celles de la figure 1, sont alors insérées par les talons 16 des lamelles 1 dans les sillons parallèles et sont brasées (figure 7).

Une pile de barrettes de diodes laser selon l'invention est représentée en figure 8. Pour la réaliser les contacts supérieurs 6 sur les cales isolantes 3 sont d'abord étamés. Puis les talons 16 des sous ensembles sont introduits dans les sillons 18, et une pression est exercée pour serrer les sous-ensembles les uns contre les autres, simultanément à la fusion de la brasure 19 dans les sillons 18 et de l'étamage sur les cales isolantes 3: les barrettes de diodes se trouvent ainsi à la fois montées sur un support 17 et connectées électriquement en série.

Un radiateur 24 peut être fixé sur la face inférieure 23 du support 17. Ce radiateur est symbolisé par un simple rectangle, car ce peut être un radiateur à ailettes, une boîte à eau ou une masse de grand inertie thermique.

Dans une variante de réalisation, on ne dépose pas de couche métallique 32 ni de brasure 34 mais les talons 16 des lamelles 1 sont collés - au lieu d'être brasés - avec une colle isolante électrique et bonne conductrice de la chaleur par exemple une colle chargée de diamant dans les sillons 18 dont les parois sont diamantées.

On peut prévoir que les différentes barrettes 1+2+3 sont d'abord brasées ensemble pour former un peigne, dont les dents qui sont les talons 16 sont ensuite collées collectivement dans les sillons 18.

A titre d'exemple non limitatif, chacun des sous-ensembles de la figure 8 comprend une lamelle 1+16 de 170 µm d'épaisseur et une cale isolante 3 de 200 µm d'épaisseur (+ 30 µm de brasure Pb - Sn sur la cale).

Les sillons 18 ont 220 µm de largeur et les cloisons céramiques qui les séparent ont 180 µm d'épaisseur, ce qui correspond un pas de 400 µm = 0,4 mm. Entre les parois de chaque sillon 18 (220 µm) et la lamelle 1 + 16 (170 µm) qui pénètre dans ledit sillon, il y a un jeu de 50 µm, qui permet d'ajuster les positions des talons 16 des lamelles, et qui est rempli par la brasure 19, fondue pendant le réglage puis solidifiée.

Bien entendu, entre dans le champ de l'invention le cas où le support 17 est préparé à partir d'une plaque métallique de grandes dimensions qui, après usinage et métallisations, est découpée en supports aux dimensions requises par la longueur et le nombre de barrettes.

La pile de barrettes lasers selon l'invention a l'avantage de disposer, grâce aux talons 16 qui pénètrent dans le support 17, d'un bon contact thermique qui assure par conséquent une bonne stabilité thermique des lasers, condition nécessaire à la stabilité de la longueur d'onde émise. A titre d'exemple, avec un pas d'empilement de 400µm, et pour un fonctionnement en impulsions de 200 µs à la fréquence 100 Hz, une pile selon l'invention a une densité de puissance optique de 1,5 kW/cm2 et une largeur spectrale inférieure à 3 nm.

Dans une variante de réalisation, on ne fabrique pas des barrettes sous forme de sous-ensembles d'une barrette de diode fixée sur une lamelle métallique avec une entretoise de liaison électrique et d'espacement, mais les barrettes de diode sont montées directement dans le bloc rainuré: la barrette 2 (cf. figure 1) est un parallélépipède mince dont les faces planes principales sont les faces d'amenée de courant. Ces faces peuvent remplir directement le rôle du talon de la lamelle et être insérées dans les sillons du bloc métallique après que ces sillons ont été isolés par un dépôt de carbone diamant et ont été revêtus d'un dépôt conducteur 32 et de la couche de brasure 34.

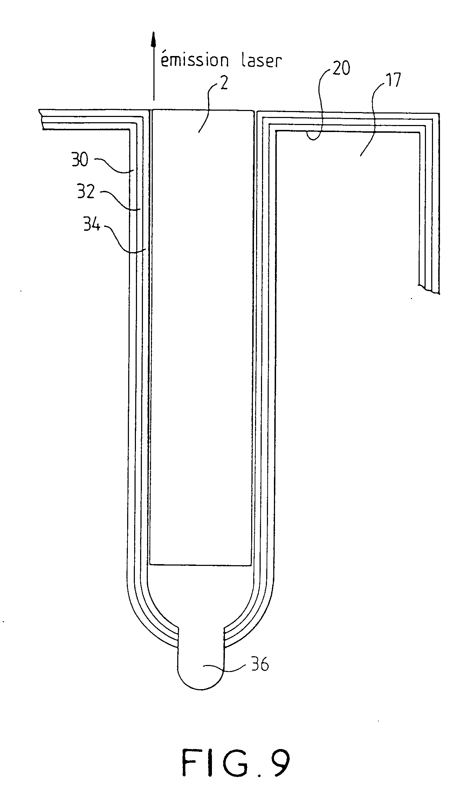

Dans ce cas, le dépôt conducteur ne sert pas qu'à la brasure. Il sert aussi à la liaison électrique entre les barrettes. Il ne faut pas éliminer le dépôt métallique et la brasure sur la face supérieure du bloc entre les sillons, car c'est ce dépôt superficiel qui relie la face d'une barrette à la face adjacente de la barrette suivante. Mais bien sûr il faut éliminer le dépôt métallique et la brasure en fond de sillon pour ne pas court-circuiter les deux faces d'une même barrette. Cette élimination peut être effectuée par un trait de scie 36 en fond de sillon (figure 9).

Les barrettes de diode peuvent alors être insérées soit en partie soit même de préférence en totalité dans les sillons si ceux-ci ont une profondeur suffisante. L'introduction des barrettes dans les sillons peut se faire en donnant temporairement une courbure convexe à la surface du bloc 17 pendant l'introduction, de manière à élargir les ouvertures de rainures. La flexion du support 17 est relâchée après introduction des barrette. Ceci est possible avec un bloc métallique du fait qu'il est assez flexible, alors que c'est difficilement envisageable avec un support de céramique.

## Revendications

1. Pile de sous-ensembles de barrettes de diodes laser, comprenant un support (17) commun rainuré, en un matériau bon conducteur thermique, et une pluralité de sous-ensembles (1) de barrettes (2) de diodes dont une partie au moins est insérée dans des sillons (18) du support, caractérisée en ce que le support (17) est en métal et en ce que les sillons sont revêtus sur leurs faces latérales intérieures d'une couche isolante (30).

2. Pile de barrettes selon la revendication 1, caractérisée en ce que les faces intérieures des sillons sont revêtues d'un dépôt conducteur (32) sur le dépôt isolant.

3. Pile de barrettes selon la revendication 2, caractérisée en ce que le dépôt conducteur est revêtu d'un dépôt de brasure (34), les sous-ensembles comportant une barrette de diodes montées sur une lamelle métallique présentant un talon arrière inséré dans les sillons et brasé aux faces intérieures des sillons.

4. Pile de barrettes selon la revendication 1, caractérisée en ce que les sous-ensembles sont constitués de barrettes de diodes montées sur une lamelle métallique, la lamelle (1) ayant un talon (16) collé dans un sillon par une colle isolante.

5. Pile de barrettes selon la revendication 2, caractérisée en ce que le dépôt conducteur est présent également en surface du support entre les sillons et relie électriquement une face d'un sillon à une face d'un sillon adjacent, les sous-ensembles étant des barrettes de diode parallélépipèdiques minces directement insérées dans les sillons et le dépôt conducteur étant supprimé en fond de sillon pour isoler électriquement entre elles les faces antérieures d'un même sillon.

6. Pile de barrettes selon la revendication 5, caractérisée en ce que les barrettes sont complètement insérées dans les sillons.

7. Pile de barrettes selon les revendications 5 ou 6, caractérisée en ce que le dépôt conducteur est revêtu d'un dépôt de brasure, les barrettes étant brasées aux faces des sillons.

8. Pile de barrettes selon l'une des revendications 1 à 7, caractérisée en ce que le dépôt isolant est un dépôt de carbone diamant.
